# EUROPÄISCHE PATENTSCHRIFT

(11) **EP 2 026 644 B1**
(45) Veröffentlichungstag und Bekanntmachung des Hinweises auf die Patenterteilung: **03.11.2010**
(21) Anmeldenummer: 08013591.6
(22) Anmeldetag: 29.07.2008
(51) Int. Cl.: H05K 13/02

(54) **Trägerband zur Aufnahme elektronischer Bauteile**
Carrier belt for carrying electronic components
Bande de support destinée à la réception de composants électroniques

(30) Priorität: 08.08.2007 DE 102007037506
(43) Veröffentlichungstag der Anmeldung: 18.02.2009
(73) Patentinhaber: Amphenol-Tuchel Electronics GmbH, 74080 Heilbronn (DE)
(72) Erfinder: Kuntz, Julio, 74861 Neudenau (DE); Brückmann, Eckhard, 74193 Stetten (DE)

(56) Entgegenhaltungen:
- DE-A1- 3 434 717
- DE-A1- 4 428 761
- US-A- 4 583 641

## Beschreibung

Die Erfindung betrifft ein Trägerband zur Aufnahme elektronischer Bauteile gemäß Anspruch 1 und ein Verfahren zur Bestückung eines solchen Trägerbandes gemäß Anspruch 8.

Die Erfindung betrifft daher ein Trägerband zur Aufnahme elektronsicher Bauteile in Ausnehmungen dieses Trägerbandes durch eine Positionierfolie hindurch.

Im Stand der Technik sind unterschiedliche Arten von Trägerbändem bekannt um elektronische Bauteile aufzunehmen und zu fixieren.

In der GB 1 289 840 erstreckt sich ein Klebeband über die ganze Breite eines Trägerbandes, welches in Folge ihrer Klebeschicht die elektronischen Bauelemente hält. Zum Entfernen dient ein Absaugen der Kleinteile vom Klebeband welches allerdings häufig daran scheitert, dass die Kleinteile an den Klebeböden zu fest haften und dadurch das Klebeband zerreist, beziehungsweise die Entnahme problematisch ist.

In einer Weiterentwicklung eines solchen Trägerbandes zur Positionierung und zur Fixierung von elektronischen Bauelementen offenbart die DE 3 327 612 ein Trägerband mit einem doppelseitigem Klebeband welches so ausgebildet ist, dass Teile des Klebebandes mit Ablösepapierstreifen abgedeckt sind und das die Breite des Klebebandes und des Ablösepapierstreifens geringer als diejenigen der Löcher sind in welche die elektronischen Bauteile eingebracht werden. Dank der Tatsache, dass das Klebeband die Löcher des Trägerbandes nicht vollständig bedeckt, sondern stattdessen Öffnungen hinterlässt, werden mehrere Vorteile erreicht, insbesondere die einfacherer Entnahme der Kleinteile beziehungsweise der elektronischen Bauelemente.

Nachteilig ist jedoch, dass die Kleinteile mit Klebestücke versehen sind um diese später auf elektronische Schaltungen, Leiterplatten oder an den gewünschten Ort einer Schaltung zu bringen.

Ist beispielsweise ein solcher Klebeabschnitt unerwünscht, muss dieser in einem zwischengeschalteten Schritt von dem elektronischen Bauelement entfernt werden.

Ein weiterer Nachteil besteht darin, dass bei zunehmender Miniaturisierung der elektronischen Bauelemente diese bedingt durch ihre sehr kleinen Abmessungen entweder mangels Adhäsion sauber an solchen Klebestreifen haften und weiterhin auch bezüglich ihrer Lage im Trägerband nicht sauber positioniert werden können. Zur Entnahme der elektronischen Bauelemente aus einem solchen Trägerband werden üblicherweise mechanische, automatisierte Entnahmevorrichtungen verwendet, welche mittels eines Roboterarms oder einer anderen Entnahmeeinrichtung, die Bauelemente aus der Verpackung, sprich dem Verband entnimmt und dann an den Einbauort transportiert, beispielsweise eine Leiterplatte und auf dieser montiert und befestigt wird. Die endgültige Lage eines solchen elektronischen Bauelementes auf der Leiterplatte hängt von mehreren Faktoren ab. Neben der Positioniergenauigkeit, hängt die endgültige Lage im Wesentlichen von der exakten Lage des Bauelementes im Trägerband ab. Insbesondere bestimmt auch die Toleranz der Aussparungen, die häufig gebildet werden durch Stanzprozesse in das Trägerband hinein, die exakte Endposition.

Die US 4583641 zeigt beispielsweise ein Verpackungsbandsystem mit einem Trägerband, in welchem eine Vielzahl von Ausstanzungen vorgesehen sind, durch welche Bauelemente mit ihren Anschlussenden hindurch positioniert werden. Da allerdings die Lagegröße und -position dieser Durchbrüche beziehungsweise Gelöcher im Trägerband toleranzbehaftet sind und gleichzeitig die Lage, der Abstand und die Position der Anschlussenden der Kontakte der Bauelemente ebenfalls fertigungsbedingten Toleranzen unterliegen, kommt es hier regelmäßig zu Schwierigkeiten, dass das Bauelement nicht identisch mit allen Anschlusselementen durch die Löcher des Trägerbandes hindurch positioniert werden kann.

In ähnlicher Weise zeigt die Druckschrift JP 03029762 A (Patent Abstracts of Japan) ein Verpackungsbandsystem mit einem Trägerband indem ebenfalls zwei paarweise beabstandete Löcher, vorgestanzte Löcher, in das Tapeband eingebracht sind.

Diese Löcher sind vorgesehen, damit die Kontaktenden der Bauelemente durch diese hindurch montiert werden können, so dass das Bauelement letztendlich auf der Oberfläche des Trägerbandes zu liegen kommt, während die Kontaktbeine sich durch die Löcher des Trägerbandes hindurch erstrecken. Hierbei taucht ebenfalls, wie zuvor genannt, das Problem auf, dass selbst bei einer niedrigen Anzahl von Kontaktanschlüssen oder Kontaktbeinchen an Bauelementen, diese einer fertigungsbedingten Toleranz unterliegen und entsprechend die Löcher zur Montage entweder so groß ausgebildet werden, dass eine exakte Position nicht bestimmbar ist und die Bauelemente herausfallen.

Diesbezüglich sieht die JP 03029762 A ein spezielles Abdeckband vor, welches sich mit allerdings erheblichem Montageaufwand in Aussparungen am Trägerband arretieren lässt und über Abschnitte verfügt, die die Bauelemente in ihrer relativen Lage zueinander festhalten.

Die US 4,583,641 offenbart eine andere Möglichkeit, elektronische Bauelemente auf einem Trägertape zu befestigen.

Auf dem dort gezeigten Tape werden in einem seriell definierten Abstand Bauelemente von einem Abdeckband gehalten, wobei das Abdeckband zwischen den einzelnen Bauelementen über Halteabschnitte verfügt, welche in Aussparungen des Trägerbandes eingreifen und die Folie daran halten.

Werden allerdings die Toleranzen und damit die Verschiebungen der Bauelemente im Trägerband unterschiedlich von Bauelement zu Bauelement, so ist eine präzise Wiederholgenauigkeit beim Positionieren der Bauelemente auf Leiterplatten oder in automatisierten Prozessen nicht gegeben.

Ein weiterer Nachteil besteht häufig darin, dass die Bauelemente, die in Löchern des Trägerbandes positioniert sind, von einem Aufnahmeraum umgeben sein müssen, in welche Greifer oder Greifmittel einer Entnahmevorichtung eintauchen können, um die Bauelemente zu umgreifen und aus den Verpackungslöchern zu entnehmen.

Dieser Bauraum bringt allerdings zusätzliche Toleranzen für die Lage des Bauelementes innerhalb des Loches. Liegt das Bauelement nicht exakt an ein und derselben Position über das gesamte Trägerband, so kommt es regelmäßig zu Störungen bei der Entnahme und der definierten Positionierung solcher Bauelemente auf der Leiterplatte.

Nachteilig in den Ausführungsformen im Stand der Technik ist, wie bereits erläutert, die Problematik der Toleranzen und die damit verbundenen Montageprobleme. Insbesondere werden in Summe die Toleranzprobleme auf der Anschlussseite des Bauelementes kumuliert mit den Toleranzproblemen der exakten Ausstanzung im Trägerband.

Ein weiterer Nachteil besteht darin, dass selbst wenn die Toleranzen deutlich verringert werden, sich noch eine relativ Verschiebung durch eine Montagevorrichtung und Handhabungsautomatislerung ergeben kann. Es ist nämlich weiterhin notwendig, dass die Bauelemente exakt über die Montagelöcher des Trägerbandes positioniert werden und durch diese hindurch montiert werden.

Es ist daher Aufgabe der vorliegenden Erfindung, ein Trägerband zur Aufnahme elektronischer Bauteile derart bereit zu stellen, fertigungsbedingte Toleranzen bei der Montage nicht zu Schwierigkeiten führen.

Aufgabe der vorliegenden Erfindung ist es daher, ein Trägerband dahingehend zu verbessern, dass die elektronischen Bauelemente zwar einerseits sicher am Trägerband gehalten werden, aber gleich wohl leichter vom Trägerband abgenommen werden können und insbesondere in ihrer Lage exakt und sauber am Trägerband positioniert sind.

Weitere Aufgabe der vorliegenden Erfindung besteht auch darin, dass exakte Positionieren dahingehend zu bewerkstelligen, dass die Bauelemente sich oberhalb des eigentlichen Trägerbandes zumindest teilweise oberhalb befinden, so dass Greifarme oder Entnahmemittel einer Entnahmevorrichtung diese präzise greifen und entnehmen können.

Diese Aufgabe wird erfindungsgemäß durch die Merkmale von Anspruch 1 gelöst.

Ein Verfahren zur Bestückung des erfindungsgemäßen Trägerbandes und zur Entnahme wird mit Anspruch 7 gelöst.

Diese Aufgabe wird erfindungsgemäß also dadurch gelöst, dass ein Trägerband bereitgestellt wird, welches über Ausnehmungen verfügt, oberhalb derer sich eine Positionierfolie befindet, durch die hindurch die elektronischen Bauelemente hindurch gesteckt werden und dadurch von der Positionierfolie exakt in einer vordefinierten Lage gehalten werden.

Anders ausgedrückt, wird die Aufgabe erfindungsgemäß dadurch gelöst, dass das Trägerband selbst eine Positionierfolie umfasst, welche über vorzugsweise eine transparente und geschlossene Beschaffenheit verfügt. Das bedeutet, die elektronischen Bauelemente werden durch eine geschlossene Positionierfolie am Trägerband hindurch gesteckt, wodurch sich beim Durchstecken formgenaue Durchbrüche ergeben, in denen das Bauelement festgehalten wird. Bei Verschiebungen oder unterschiedlichen Bauelementen ist dies daher nicht von Nachteil, da keine vorgestanzten Löcher in der Positionierfolie des Trägerbandes bereit gestellt sind, sondern die Folie durchgehend, dass heißt ohne vorgestanzte Durchbrüche versehen ist.

Gleichzeitig befindet sich der Teil des Bauelementes oberhalb der Folie, der später von Greifern oder Greifmitteln einer Entnahmevorrichtung anzupacken ist. Oberhalb der Positionierfolie befindet sich eine weitere Folie, nämlich eine Abdeckfolie zum sicheren Halt der durch die Positionierfolie hindurch gesteckten elektronischen Bauelemente. Dadurch können die Aussparungen im Trägerband exakt auf das Außenmaß der elektronischen Bauelemente hin abgestimmt werden und selbst Toleranzen von kleiner als 0,3 mm (Millimeter) durch die Positionierfolie abgefangen werden. Damit gewährleistet die Positionierfolie ein sauberes Positionieren der elektronischen Bauelemente auf dem Trägerband unabhängig von der Toleranzlage der Ausnehmungen innerhalb des Trägerbandes. Im Verfahren beim Bestücken eines erfindungsgemäßen Trögerbandes durch die Positionierfolie hindurch wird gewährleistet, dass die relative Lage des Bauelemente losgelöst ist von der relativen Lage der darunter befindlichen Ausnehmungen. Dadurch wird eine verbesserte Positionier- und Wiederholgenauigkeit beim Bestücken eines Trägerbandes erreicht.

Vorteilhafte Weiterbildungen bestehen beispielsweise darin, dass das Trägerband mit einer Positionierfolie abgedeckt wird, die im Bereich der später aufzunehmenden Bauelemente bereits Vorstanzungen aufweißt, um das Hindurchstecken der elektrischen Bauelemente durch das Trägerband hindurch zu erleichtern. Alternativ können statt einer durchgehenden Positionierfolie auch sequenzielle Positionierfolien direkt oberhalb der Ausnehmungen für die elektronischen Bauelemente angebracht werden. Anhand der Zeichnungen, die ein Ausführungsbeispiel beschreibt, sei die Erfindung näher beschreiben. Es zeigt:
Fig. 1 eine perspektivische Ansicht eines erfindungsgemäßen Trägerbandes;
Fig. 2 einen Schnitt durch das Trägerband entsprechend Fig. 1.

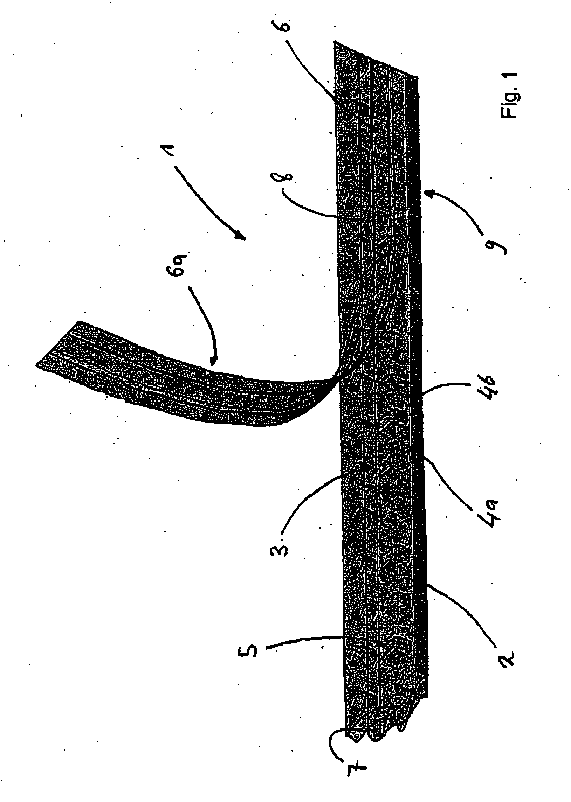

In Fig. 1 ist allgemein ein Verpackungsband 1 gezeigt, welches aus einem Trägerband 2 gebildet ist. Das Trägerband 2 erstreckt sich im Wesentlichen in X-Richtung in seiner Längenausstreckung, wobei die Y-Richtung die Breite des Trägerbandes 2 definiert. Die Dicke des Trägerbandes 2, welches sich in Z-Richtung erstreckt, ist in dem vorliegenden Falle abgestimmt auf die Größe des darin aufzunehmenden elektronischen Bauelements 5. Das Trägerband 2 weist entlang einer seiner Längsseitenkante etwas versetzt nach innen Transportlöcher 3 auf, die dazu dienen, dass Trägerband in einem automatisierten Prozess an entsprechenden mechanischen Vorschubeinrichtungen entlang zu transportieren und beispielsweise auf- oder abzuwickeln zu einer Transport- und Verpackungsbandrolle. In dem Trägerband 2 befinden sich in einem festen Abstand voneinander entlang der X-Achse über das gesamte Band verteilt Aussparungen 4a, 4b. Die Aussparungen 4a, 4b sind so geformt, dass sie Teile von elektronischen Bauelementen 5 aufnehmen können. Oberhalb des Bereiches, entlang der Längsersteckung des Trägerbandes 2, befindet sich in etwa über die Hälfte des Trägerbandes 2 eine Positionierfolie 7, die die Aussparungen 4a, 4b abdeckt, sofern keine elektronischen Bauelemente in das Trägerband 2 beziehungsweise deren Ausnehmungen 4a, 4b eingebracht wurden. Vorzugsweise verlaufen die Ausnehmungen 4a, 4b beabstandet vom Längsseitenrand des Verpackungsbandes 1 beziehungsweise des Trägerbandes 2. In die Aussparungen 4a, 4b sind elektronische Bauelemente mit korrespondierender Kontur durch die Positionierfolie 7 hindurch gesteckt eingebracht.

Oberhalb der Positionierfolie 7 und oberhalb der in die Aussparungen 4a, 4b eingebrachten elektronischen Bauelemente 5 ist eine Abdeckfolie 6 aufgebracht, die die elektronischen Bauelemente 5 vor unbeabsichtigtem Herausnehmen oder Herausfallen schützt.

In der Fig. 1 wird die Abdeckfolie 6 so dargestellt, dass diese nur im rechten Bereich des hier abschnittsweise dargestellten Verpackungsbandes 1 oberhalb der Positionierfolie 7 über diese angebracht ist und einen Bereich 6a sich im noch nicht aufgebrachten Zustand befindet. Vorzugsweise ist die Abdeckfolie 6 und die Positionierfolie 7 transparent ausgebildet, so dass auch eine optische, sprich visuelle Begutachtung des Verpackungszustandes mit den elektronischen Bauelementen erfolgen kann.

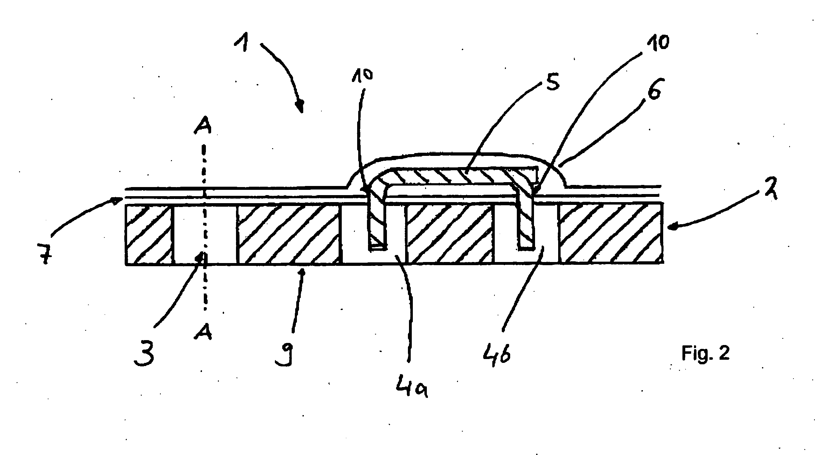

In Fig. 2 ist im Schnitt verdeutlicht, wie die Abfolge von Trägerband 2, Positionierfolie 7 und Abdeckfolie 6 am Trägerband 2 bewerkstelligt ist. Im linken Bereich dargestellt sind die schon in Fig. 1 beschriebenen Transportlöcher 3, die sich von der oberen Ebene des Trägerbandes 2 bis an deren Außenseite 9 hindurch durch das Trägerband 2, erstrecken. Dazu beabstandet befindet sich eine erste Aussparung 4a zur Aufnahme eines Teils eines elektronischen Bauelementes 5. Dazu beabstandet befindet sich ein weiterer Aussparung 4b, ebenfalls zur Aufnahme des zuvor beschriebenen elektrischen Bauelementes 5 mit einem weiteren Teil dieses Bauelementes 5. Die Aussparung 4b wiederum ist beabstandet vom Längsseitenrand des Trägerbandes 2. Oberhalb der Oberseite des Trägerbandes 2 befindet sich die Positionierfolie 7, welche von dem elektronischen Bauelement 5 an den Durchbrüchen 10 durchstoßen ist. Die Durchbrüche 10 halten das Bauelement 5 in X/Y-Ebene in Position, so dass ein Verschieben in X,- oder ein Verschieben in Y-Richtung ausgeschlossen ist. Ein Teil des elektronischen Bauelementes 5 kommt oberhalb der Positionierfolie 7 zu liegen. Dieser Teil kann später von entsprechenden Greifwerkzeugen gegriffen und an die gewünschte Einbaustelle transportiert werden. Die Positionierfolie 7 und das elektronische Bauelement 5 werden vorzugsweise von einer Abdeckfolie 6 über ihren gesamten Bereich hin abgedeckt.

Alternativ könnte auch nur ein Teil der Positionierfolie 7 bedeckt sein. Ebenfalls könnte die Positionierfolie 7 auch über den gesamten Oberflächenbereich des Trägerbandes 2 verlaufen und an den Transportlöchern 3 Aussparungen beziehungsweise Ausstanzungen aufweisen.

Die Abdeckfolie 6 kann zur Entnahme der elektronischen Bauelemente 5 von dem Trägerband 2 sprich zerstörungsfrei von der Positionierfolie 7 abgelöst werden. Dadurch wird das elektronische Bauelement 5 für Greifroboter oder Händlingsautomaten zugänglich. Nach dem Entfernen der Abdeckfolie 6, wie bei dem Abdeckfolienabschnitt 6a gezeigt, bleiben die elektronischen Bauelemente 5 bezüglich ihrer horizontalen und vertikalen Lage bedingt durch das Festhalten der elektronischen Bauelemente 5 durch die Positionierfolie 7 in ihrer Lage fest gehalten. Erfindungsgemäß wird dadurch ein exaktes Positionieren der elektronischen Bauelemente bis zur Entnahme erzielt.

## Patentansprüche

1. Verpackungsband (1) zur Aufnahme von elektronischen Bauelementen (5) umfassend ein Trägerband (2) mit Aussparungen (4a, 4b) zur Aufnahme der Bauelemente, wobei das Trägerband (2) eine Außenseite (9) und eine Bestückungsseite (8) aufweist, sowie einer Abdeckfolie (6) zum Abdecken elektronischer Bauelemente, die sich auf der Oberfläche des Verpackungsbandes (1) befindet, **dadurch gekennzeichnet, dass** das Verpackungsband (1) eine zweite Folie, nämlich eine Positionierfolie (7) zur Positionierung der Bauelemente aufweist, die sich zwischen der Bestückungsseite (8) des Trägerbandes (2) und der Abdeckfolie (6) befindet und dass die zweite Folie (7) im Bereich der Aussparungen (4a, 4b) keinerlei Montagelöcher zur Aufnahme der elektronischen Bauelemente aufweist.

2. Verpackungsband (1) gemäß Anspruch 1, **dadurch gekennzeichnet, dass** die Aussparungen (4a, 4b) zur Aufnahme von elektronischen Bauelementen (5) vollständig durch die Positionierfolie (7) abgedeckt sind.

3. Verpackungsband (1) gemäß Anspruch 1 oder 2, **dadurch gekennzeichnet, dass** die zweite Folie (7) so beschaffen ist, dass sich Kontaktenden elektronischer Bauelemente, vorzugsweise Lötkontaktbeinchen, durch die Folie (7) unter Bildung von Durchbrüchen durchstoßen lassen.

4. Verpackungsband (1) gemäß einem der vorhergehenden Ansprüche, **dadurch gekennzeichnet, dass** die zweite Folie (7) eine transparente Positionierfolie darstellt, die so ausgebildet ist, dass elektrische Bauelemente (5) durch diese hindurch gesteckt werden können und dann von dieser Folie (7) fest fixiert werden.

5. Verpackungsband (1) gemäß Anspruch 4 **dadurch gekennzeichnet, dass** dieses mit elektronischen Bauelementen (5) bestückt ist, welche die Positionierfolie (7) an den Stellen der Aussparungen (4a, 4b) durchstoßen und die elektrischen Bauelemente (5) von der Positionierfolie (7) an den Durchbrüchen (10) gehalten werden.

6. Verpackungsband (1) gemäß Anspruch 5, **dadurch gekennzeichnet, dass** die elektronischen Bauelementen (5) zumindest teilweise in die Aussparungen (4a, 4b) ragen und die Positionierfolie (7) an den Stellen der Aussparungen (4a, 4b) durchstoßen sind und sich Teile der Bauelemente (5) oberhalb der Positionierfolie (7), jedoch unterhalb der Abdeckfolie (6) befinden.

7. Verfahren zum Bestücken eines Verpackungsbandes (1) gemäß einem der vorhergehenden Ansprüche, **gekennzeichnet durch** die folgenden Schritte:
- Transportieren des Verpackungsbandes (1) entlang der Transportlöcher (3) des Trägerbandes (2);
- Bestücken des Trägerbandes (2) mit elektronischen Bauelementen (5) in die Aussparung (4a, 4b) in Folge des Durchstoßen der Positionierfolie (7) mit den Anschlussenden, vorzugsweise Lötkontaktenden der elektrischen Bauelementen (5) **durch** die Folie (7) hindurch, unter Bildung von Durchbrüchen (10);
- Aufbringen eines Abdeckbandes (6) oberhalb der Positionierfolie (7) und oberhalb der Bauelemente (5).

## Claims

1. A packing belt (1) for carrying electronic components (5) comprising a carrier belt (2) with recesses (4a, 4b) to carry the components, wherein the carrier belt (2) has an outer face (9) and a component side (8), as well as a backing film (6) to cover electronic components, which is on the surface of the packing belt (1), **characterised in that** the packing belt (1) has a second film, namely a positioning film (7), to position the components, which is located between the component side (8) of the carrier belt (2) and the backing film (6) and that the second film (7) has no assembly holes to carry the electronic components close to the recesses (4a, 4b).

2. The packing belt (1) according to claim 1, **characterised in that** the recesses (4a, 4b) for carrying electronic components (5) are completely covered by the positioning film (7).

3. The packing belt (1) according to claim 1 or 2, **characterised in that** the second film (7) is such that contact ends of electronic components, preferably soldered contact legs, can pierce the film (7) producing perforations.

4. The packing belt (1) according to one of the preceding claims, **characterised in that** the second film (7) is a transparent positioning film, which is designed such that electrical components (5) can be pushed through it and then firmly fixed by this film (7).

5. The packing belt (1) according to claim 4, **characterised in that** it is fitted with electronic components (5), which pierce the positioning film (7) at the locations of the recesses (4a, 4b) and the electrical components (5) are held by the positioning film (7) at the perforations (10).

6. The packing belt (1) according to claim 5, **characterised in that** the electronic components (5) project at least partially into the recesses (4a, 4b) and the positioning film (7) is pierced at the locations of the recesses (4a, 4b) and parts of the components (5) are located above the positioning film (7), but below the backing film (6).

7. A method of fitting components to a packing belt (1), according to one of the preceding claims, **characterised by** the following steps:
- transportation of the packing belt (1) along the transport holes (3) of the carrier belt (2);
- fitting of the carrier belt (2) with electronic components (5) in the recess (4a, 4b) following piercing of the positioning film (7) with the connection ends, preferably soldered contact ends of the electrical components (5), through the film (7), creating perforations (10);
- fitting of a backing strip (6) above the positioning film (7) and above the components (5).

## Revendications

1. Bande d'emballage (1) pour le logement de composants électroniques (5), comprenant une bande support (2) avec des évidements (4a, 4b) pour le logement des composants, la bande support (2) comprenant un côté extérieur (9) et un côté de montage (8), ainsi qu'un film de protection (6) recouvrant les composants électroniques, qui se trouve à la surface de la bande d'emballage (1), **caractérisée en ce que** la bande d'emballage (1) comprend un deuxième film, à savoir un film de positionnement (7) pour le positionnement des composants, qui se trouve entre le côté de montage (8) de la bande support (2) et le film de protection (6) et **en ce que** le deuxième film (7) ne comprend, au niveau des évidements (4a, 4b) aucun trou de montage pour le logement des composants électroniques.

2. Bande d'emballage (1) selon la revendication 1, **caractérisée en ce que** les évidements (4a, 4b) sont recouverts par le film de positionnement (7) pour le logement de composants électroniques (5).

3. Bande d'emballage (1) selon la revendication 1 ou 2, **caractérisée en ce que** le deuxième film (7) est conçu de telle sorte que les extrémités de contact des composants électronique, de préférence des pattes de contact à braser, peuvent traverser le film (7) en réalisant des perforations.

4. Bande d'emballages (1) selon l'une des revendications précédentes, **caractérisée en ce que** le deuxième film (7) constitue un film de positionnement transparent conçu de façon à ce que des composants électriques (5) puissent être insérés à travers celui-ci puis être fermement immobilisés par ce film (7).

5. Bande d'emballage (1) selon la revendication 4, **caractérisée en ce que** celle-ci est munie de composants électroniques (5) qui traversent le film de positionnement (7) au niveau des évidements (4a, 4b) et les composants électriques (5) sont maintenus par le film de positionnement (7) au niveau des perforations (10).

6. Bande d'emballage (1) selon la revendication 5, **caractérisée en ce que** les composants électroniques (5) dépassent au moins partiellement dans les évidements (4a, 4b) et le film de positionnement (7) est perforé au niveau des évidements (4a, 4b) et des parties des composants (5) se trouvent au-dessus du film de positionnement (7) mais en dessous du film de protection (6).

7. Procédé de garnissage d'une bande d'emballage (1), selon l'une des revendications précédentes, **caractérisé par** les étapes suivantes :
- Transport de la bande d'emballage (1) le long des trous de transport (3) de la bande support (2);
- Garnissage de la bande support (2) avec des composants électroniques (5) dans l'évidement (4a, 4b) après la traversée du film de positionnement (7) par les extrémités de connexion, de préférence des extrémités de contact à braser des composants électroniques (5) à travers le film (7), en formant des perforations (10);
- Application d'une bande de protection (6) au-dessus du film de positionnement (7) et au-dessus des composants (5).
